# EUROPÄISCHE PATENTSCHRIFT

(11) **EP 3 430 656 B1**
(45) Veröffentlichungstag und Bekanntmachung des Hinweises auf die Patenterteilung: **09.06.2021**
(21) Anmeldenummer: 17708192.4
(22) Anmeldetag: 21.02.2017
(51) Int. Cl.: H01L 51/52, H01L 51/54, H01L 51/56

(54) **ORGANISCHE ELEKTRONENLEITENDE SCHICHT MIT N-DOTIERSTOFF**
N-DOPED ORGANIC ELECTRON CONDUCTING LAYERS
COUCHE ORGANIQUE CONDUCTRICE D'ÉLECTRONS À DOPAGE N

(30) Priorität: 13.05.2016 DE 102016208298
(43) Veröffentlichungstag der Anmeldung: 23.01.2019
(73) Patentinhaber: Siemens Aktiengesellschaft, 80333 München (DE)
(72) Erfinder: KESSLER, Florian, 96193 Wachenroth (DE)
(86) Internationale Anmeldenummer: PCT/EP2017/053906
(87) Internationale Veröffentlichungsnummer: WO 2017/194213

(56) Entgegenhaltungen:
- DE-A1-102006 054 523
- EVELYN WUTTKE ET AL: "Palladium Alkynyl and Allenylidene Complexes: Very Efficient Precatalysts for C-C Coupling Reactions", ORGANOMETALLICS, Bd. 30, Nr. 22, 28. November 2011 (2011-11-28), Seiten 6270-6282, XP55370477, US ISSN: 0276-7333, DOI: 10.1021/om200862m
- LIQUN JIN ET AL: "Isolation of cationic and neutral (allenylidene)(carbene) and bis(allenylidene)gold complexes", CHEMICAL SCIENCE, Bd. 7, Nr. 1, 16. November 2015 (2015-11-16), Seiten 150-154, XP55315597, United Kingdom ISSN: 2041-6520, DOI: 10.1039/C5SC03654B

## Beschreibung

Die vorliegende Erfindung betrifft eine organische elektronenleitende Schicht mit einem n-Dotierstoff. Weiterhin betrifft die Erfindung ein organisches elektronisches Bauelement mit einer derartigen Schicht sowie ein Verfahren zur Herstellung einer solchen Schicht und die Verwendung des n-Dotierstoffes zur Erhöhung der Elektronenleitfähigkeit in einer organischen Schicht.

Nach dem Stand der Technik sind elektronenleitende Schichten für organische elektronische Bauelemente bekannt, bei denen bestimmte n-Dotierstoffe zur Erhöhung der Elektronenleitfähigkeit in eine Matrix eines organischen elektronenleitfähigen Materials eingebettet sind. Eine solche Einbettung über die ganze Dicke der Schicht wird im Englischen auch als "Bulk Doping" bezeichnet, im Unterschied zur Einführung einer dünnen Zwischenschicht an einer Grenzfläche, die auch eine verbesserte Elektronenleitfähigkeit bewirken kann.

Es wurden bereits verschiedene Stoffe als n-Dotierstoffe in solchen elektronenleitenden Schichten vorgeschlagen. Viele davon sind salzartige Komplexe mit einem positiv geladenen Metallatom und einem negativ geladenen organischen Liganden. Beispielsweise werden in der DE 10 2012 217 574 A1 Phosphoroxosalze als n-Dotierstoffe beschrieben. In der DE 10 2012 217 587 A1 werden Salze des Cyclopentadiens als n-Dotierstoffe beschrieben. In der DE 10 2012 205 945 A1 wird eine Elektronendonor-Verbindung zur n-Dotierung einer Elektronentransportschicht beschrieben, wobei die Elektronendonor-Verbindung mindestens zwei cyclische Carben-Gruppen aufweist, welche über eine Brücke verbunden sind, wobei die Carben-Gruppen nicht über ein Metall-Ligand-Fragment direkt miteinander verbunden sind. In der DE 10 2006 054 523 A1 werden Dithiolenübergangsmetallkomplexe und deren Selen-analoge Verbindungen als Dotand zur Dotierung eines organischen halbleitenden Matrixmaterials beschrieben.

In Evelyn Wuttke et al.: "Palladium Alkynyl and Allenylidene Complexes: Very Efficient Precatalysts for C-C Coupling Reactions", Organometallics 30 (2011) 6270-6282 wird die Verwendung der im Titel genannten Palladium Alkinyl- und Allenyliden-Komplexe als Katalysatoren beschrieben. In Liqun Jin et al.: "Isolation of cationic and neutral (allenylidene) (carbene) and bis(allenylidene)gold complexes", Chemical Science 7 (2015) 150-154 wird die Isolation von Allenyliden-, Carben- und Bis(allenyliden)-Gold-Komplexen beschrieben.

Aufgabe der Erfindung ist es, eine organische elektronenleitende Schicht bereitzustellen, in der mit einem alternativen n-Dotierstoff eine starke Elektronenleitfähigkeit erreicht wird. Eine weitere Aufgabe ist es, ein organisches elektronisches Bauelement mit einer solchen Schicht bereitzustellen sowie ein Verfahren zur Herstellung einer solchen Schicht und eine Verwendung eines n-Dotierstoffes zu Erhöhung der Elektronenleitfähigkeit einer organischen Schicht anzugeben.

Diese Aufgaben werden durch die in Anspruch 1 beschriebene Schicht, das in Anspruch 10 beschriebene organische elektronische Bauelement, das in Anspruch 13 beschriebene Verfahren und die in Anspruch 15 beschriebene Verwendung gelöst.

Die erfindungsgemäße organische elektronenleitende Schicht umfasst einen n-Dotierstoff mit der nachstehenden allgemeinen Formel (1): 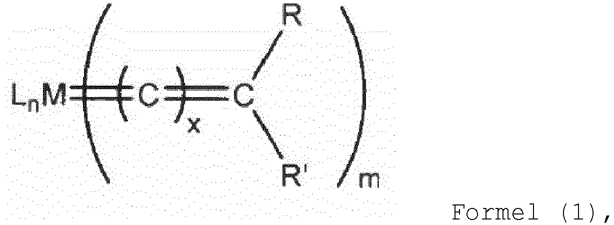 wobei Lₙ eine Anzahl n von Liganden L bezeichnet, die - auch unabhängig voneinander - aus der Gruppe der Alkyle, Aryle, Alkylaryle, Heteroalkyle, Heteroaryle, der mit funktionellen Gruppen substituierten Alkyle, Aryle, Alkylaryle, Heteroalkyle, Heteroaryle und der substituierten Heteroatome ausgewählt sind. M ist ein Metall, ausgewählt aus der Gruppe enthaltend Eisen, Ruthenium, Osmium, Kobalt, Rhodium, Iridium, Nickel, Palladium, Platin, Kupfer, Silber und Gold. R und R' sind unabhängig voneinander aus der Gruppe der Alkyle, Aryle, Alkylaryle, Heteroalkyle, Heteroaryle, der mit funktionellen Gruppen substituierten Alkyle, Aryle, Alkylaryle, Heteroalkyle, Heteroaryle und der substituierten Heteroatome ausgewählt. Außerdem liegt n zwischen 0 und 5, m liegt zwischen 1 und 6, die Summe n+m liegt zwischen 2 und 6, und x hat einen Wert von 0, 1 oder 2.

Mit anderen Worten handelt es sich bei dem n-Dotierstoff um einen Metallkomplex mit insgesamt wenigstens zwei Liganden (n+m ist wenigstens 2), wobei zumindest einer diese Liganden (m ist wenigstens 1) ein Carben (x=0), ein Vinyliden (x=1) und/oder ein Allenyliden (x=2) ist. Hierbei ist der wenigstens eine letztgenannte Ligand direkt über sein Carben-Kohlenstoffatom beziehungsweise sein endständiges Vinyliden-Kohlenstoffatom und/oder sein endständiges Allenyliden-Kohlenstoffatom an das Metallatom M gebunden. Es handelt sich also um einen Carben-, einen Vinyliden- und/oder Allenyliden-Komplex. Als Carben-Komplexe werden allgemein Substanzen bezeichnet, die eine formale Metall-sp²-Kohlenstoff-Doppelbindung aufweisen. An das sogenannte Carben-Kohlenstoffatom sind üblicherweise zwei Reste gebunden - hier R und R' im Falle des Carben-Komplexes mit x = 0, wobei im Beispiel der Formel (2) m=1 ist. Ein solcher Carben-Komplex entspricht also der allgemeinen Formel (2):

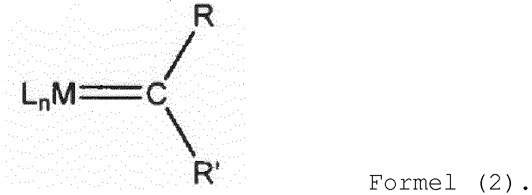

Liegt hingegen nur ein Kohlenstoff-Substituent vor, der über eine weitere Doppelbindung an das carbenartige C-Atom gebunden ist, so liegen Vinyliden-Komplexe vor. Ein solcher Vinyliden-Komplex (falls m=1) entspricht dann der allgemeinen Formel (3) :

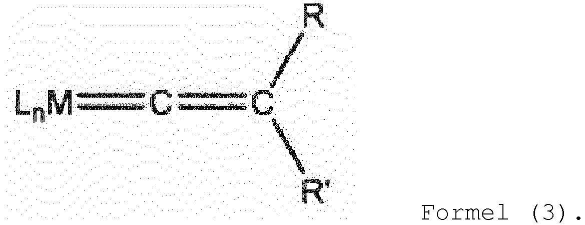

In der gezeigten Formel (3) entspricht also der rechte -CRR'-Teil dem oben genannten einen Kohlenstoff-Substituenten, und das links dargestellte Kohlenstoffatom ist hier ein carbenartiges Kohlenstoffatom, da es - abgesehen von der Komplexbindung zum Metallatom M - nur zwei kovalente Bindungen zum benachbarten Kohlenstoffatom aufweist.

Verlängert man die ungesättigte Kohlenstoffkette der Formel (3) um ein weiteres Kohlenstoffatom, so erhält man (falls m=1) einen Allenyliden-Komplex der allgemeinen Formel (4):

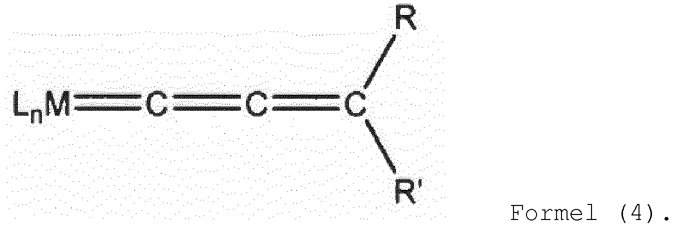

Gemäß der allgemeinen Struktur nach Formel (1) setzt sich also der n-Dotierstoff aus einem formal neutralen Metall-Liganden Fragment LₙM und mindestens einem weiteren formal neutralen Carben-, Vinyliden- und/oder Allenyliden-Liganden zusammen. Unter Komplexen der allgemeinen Struktur gemäß Formel (1) sollen dabei in jedem Fall auch solche Komplexe verstanden werden, bei denen die m einzelnen Liganden des Typs (C)ₓ=CRR' unterschiedlich gewählt sind. Dabei können insbesondere nicht nur die Substituenten R und R' der einzelnen der m Liganden unterschiedlich gewählt sein, sondern es können auch ein oder mehrere Carben-Liganden zusammen mit einem oder mehreren Vinyliden-Liganden und/oder einem oder mehreren Allenyliden-Liganden innerhalb eines Komplexes vorliegen. Die erfindungsgemäße Art der Struktur gemäß der allgemeinen Formel (1) bewirkt eine besonders hohe Lage des höchsten besetzten Molekülorbitals (= HOMO für englisch "highest occupied molecular orbital"), was sich für den Elektronentransport in der betreffenden, den n-Dotierstoff enthaltenden Schicht besonders positiv auswirkt. Dies ist zunächst unabhängig davon, ob die Schicht den n-Dotierstoff als Beimischung zu einem weiteren Elektronentransportmaterial enthält, oder ob der n-Dotierstoff selbst das wesentliche Elektronentransportmaterial in der Schicht ist.

Die Lage des HOMO ist allgemein für die beschriebene Stoffgruppe vergleichsweise hoch. Ein weiterer Vorteil der Stoffgruppe nach Formel (1) liegt darin, dass innerhalb dieser Stoffgruppe eine große strukturelle Vielfalt möglich ist, wobei alle Vertreter durch die Elektronenstruktur des an das Metallatom gebundenen letzten Carben-, Vinyliden- oder Allenyliden-Kohlenstoffatoms eine vergleichsweise hohe HOMO-Lage aufweisen. Besonders vorteilhaft ist es, wenn die genaue Lage dieses hochliegenden HOMO an die Lage der Molekülorbitale von benachbarten Schichten und/oder die Lage der Molekülorbitale eines ebenfalls in der elektronenleitenden Schicht vorliegen weiteren Materials angepasst werden kann. Dies kann vorteilhaft durch eine Anpassung der jeweiligen Substituenten R und R', der Wahl aus Carben-, Vinlyiden und Allenyliden-Ligangen (gegenenfalls in Kombination) sowie der weiteren Liganden Lₙ an die speziell gewünschten HOMO-Lagen erreicht werden. Ein weiterer allgemeiner Vorteil der n-Dotierstoffe gemäß Formel (1) ist, dass diese allgemein niedrige Sublimationstemperaturen aufweisen und daher im Vergleich zu anderen bekannten n-Dotierstoffen, insbesondere salzartigen Dotierstoffen, besonders leicht durch Vakuumprozessierung, insbesondere durch Verdampfen, in einer Schicht abgeschieden werden können. Dies ist insbesondere im Vergleich zu den schwer sublimierbaren Alkali- und Erdalkalisalzen vorteilhaft. Dieser Vorteil der erfindungsgemäßen Strukturen ergibt sich daraus, dass - auch wenn prinzipiell unterschiedliche Strukturformeln zur Darstellung verwendet werden können - der salzartige Charakter dieser Komplexe äußerst gering ist.

Besonders vorteilhaft sind Komplexe vom Typ entsprechend Formel (1), bei denen x Werte (für zumindest einen der m carbenartigen Liganden) von 1 oder 2 hat, bei denen es sich also um Vinyliden- oder Allenylidenkomplexe handelt. Dies liegt daran, dass die Leitfähigkeit entlang der linearen ungesättigten Kette von mehreren (hier 1+x, also insgesamt 2 oder 3) durch Doppelbindungen verbundenen Kohlenstoffatome auch innerhalb der Moleküle besonders hoch ist. Hierdurch wird auch auf die gesamte Schicht bezogen eine besonders gute Leitfähigkeit erreicht, und die elektrischen Verluste eines mit einer solchen Schicht gebildeten organischen elektronischen Bauteils sind vorteilhaft gering. Dieser Vorteil ist besonders wirksam für die Allenyliden-Komplexe (n=2 für wenigstens einen der m carbenartigen Liganden), bei denen eine molekülinterne elektrische Leitfähigkeit entlang einer Dreierkette von durch Doppelbindungen verbundenen Kohlenstoffatomen vorliegt. Ganz besonders vorteilhaft ist in diesem Zusammenhang, wenn wenigstens zwei Allenyliden-Liganden in einem Molekül vorhanden sind. Insbesondere wenn zwei Allenyliden-Liganden in einem Molekül linear mit dem Metallatom angeordnet sind, ergibt sich eine sehr hohe molekülinterne Leitfähigkeit, da ein Ladungstransport über eine C=C=C=M=C=C=C Kette stattfinden kann.

Das organische elektronische Bauelement weist wenigstens zwei Elektroden und eine Schicht nach einem der vorgenannten Ansprüche auf. Bei einem solchen Bauteil wirken die Vorteile der Schicht entsprechend wie oben beschrieben, und die Elektronenleitfähigkeit zwischen den beiden Elektroden durch die erfindungsgemäße Schicht ist gegenüber herkömmlichen organischen Bauelementen vorteilhaft erhöht. Dies liegt nicht nur an der guten Elektronenleitfähigkeit der erfindungsgemäßen Schicht selbst, sondern auch an der allgemein hohen Lage des HOMO. Eine solch hohe Lage des HOMO ist allgemein vorteilhaft, um negative Ladungsträger beispielsweise auf ein innerhalb derselben Schicht oder einer benachbarten Schicht vorliegendes Elektronentransportmaterial zu übertragen.

Das erfindungsgemäße Verfahren dient zur Herstellung einer erfindungsgemäßen organischen elektronenleitenden Schicht. Bei dem Verfahren wird der n-Dotierstoff mittels eines Sublimationsprozesses abgeschieden. Die n-Dotierstoffe der allgemeinen Struktur nach Formel (1) sind besonders gut geeignet, um durch Sublimation in dünnen Schichten abgeschieden zu werden.

Weiterhin wird die Verwendung eines n-Dotierstoffes mit einer allgemeinen Struktur nach Formel (1) beansprucht, um die Elektronenleitfähigkeit einer organischen Schicht zu erhöhen.

Vorteilhafte Ausgestaltungen und Weiterbildungen der Erfindung gehen aus den von den Ansprüchen 1, 10 und 13 abhängigen Ansprüchen sowie der folgenden Beschreibung hervor. Dabei können die beschriebenen Ausgestaltungen der Schicht, des Bauelements, des Verfahrens und der Verwendung allgemein vorteilhaft miteinander kombiniert werden.

So kann der Rest R und/oder der Rest R' für zumindest einen der m carbenartigen Liganden vorteilhaft ein substituiertes Heteroatom sein. Insbesondere kann es sich bei R und/oder R' um jeweils eine Methoxy- oder Aminogruppe handeln. Allgemein kann an dieser und an anderer Stelle des n-Dotierstoffes die Wahl von Heteroatomen vorteilhaft sein, um eine Feinabstimmung der Leitfähigkeit und/oder der Lage des HOMO an die elektrischen Eigenschaften einer übrigen Komponente der Schicht und/oder einer benachbarten Schicht zu erreichen.

R und R' können auch für zumindest einen der m carbenartigen Liganden vorteilhaft als gemeinsamer gesättigter oder ungesättiger Carbo- oder Heterocyclus verbrückt sein, beispielsweise als Pyrrol, Pyrazol oder Imidazol. Die Heteroatome können dabei in beliebiger Position im Ring auftreten. Mit anderen Worten können R und R' (oder zumindest Teile davon) zusammen mit dem in Formel (1) rechts dargestellten Kohlenstoffatom Teil eines solchen Carbo- oder Heterocyclus sein. Hierbei sind besonders Ringe aus 4, 5, 6, 7 oder 8 cyclisch verbundenen Atomen bevorzugt. Diese Ringe können auch substituiert sein, beispielsweise durch Substituenten ausgewählt aus der Gruppe der Alkyle, Aryle, Alkylaryle, Heteroalkyle, Heteroaryle, der mit funktionellen Gruppen substituierten Alkyle, Aryle, Alkylaryle, Heteroalkyle, Heteroaryle und der substituierten Heteroatome.

Einer oder mehrere der n Liganden L können besonders vorteilhaft als substituierte Benzyl-Liganden ausgebildet sein. Bei der Wahl von einem oder mehreren Liganden L als substituiertes Heteroatom kann dies insbesondere ein Ligand des Typs - PR"₃ oder -NR"₂ sein, wobei P für Phosphor, N für Stickstoff und R" für einen von mehreren (3 oder 2) Resten steht, die jeweils unabhängig voneinander aus der Gruppe der Alkyle, Aryle, Alkylaryle, Heteroalkyle, Heteroaryle, der mit funktionellen Gruppen substituierten Alkyle, Aryle, Alkylaryle, Heteroalkyle, Heteroaryle und der substituierten Heteroatome ausgewählt sein können.

Es können allgemein auch mehrere Liganden L als übergeordnete Ringstruktur miteinander verbrückt sein. Diese können als wenigstens ein gesättigter oder ungesättigter Carbo- oder Heterocyclus verbrückt sein, beispielsweise in Form einer ligandenübergreifenden Bipyridin-, Phenylpyridin, Terpyridin-oder 1,2-Bis(diphenylphosphino)ethanstruktur. Mit anderen Worten kann es sich bei der übergeordneten Struktur der Liganden L dann um einen gemeinsamen mehrzähnigen Liganden handeln. Allgemein kann bei einer verbrückten heterocyclischen Struktur das Heteroatom beziehungsweise die Heteroatome in beliebiger Position im Ring auftreten. Auch hier werden, unabhängig davon, ob es sich um einen Carbo- oder Hetero-Metallacyclus handelt, Ringe aus 4, 5, 6, 7 oder 8 cyclisch verbundenen Atomen bevorzugt. Unter einem solchen Metallacyclus soll allgemein ein Cyclus verstanden werden, der sich über das Metallatom und zwei Liganden erstreckt. Diese Ringe können auch substituiert sein, beispielsweise durch Substituenten ausgewählt aus der Gruppe der Alkyle, Aryle, Alkylaryle, Heteroalkyle, Heteroaryle, der mit funktionellen Gruppen substituierten Alkyle, Aryle, Alkylaryle, Heteroalkyle, Heteroaryle und der substituierten Heteroatome.

Das Metallatom M kann bevorzugt aus der Gruppe enthaltend Palladium, Platin, Silber oder Gold ausgewählt sein. Dabei ist Gold besonders bevorzugt, da sich mit Gold als Metallatom besonders leicht neutrale Komplexe durch Reduktion von geladenen Komplexen herstellen lassen. Das Metall Platin kann aber auch aus der in Anspruch 1 genannten Gruppe ausgeschlossen sein, da Platin in bekannten Emittermaterialien für organische elektronische Leuchtdioden zum Einsatz kommt. Bei der erfindungsgemäßen Schicht soll es sich jedoch nicht vorrangig um eine Emitterschicht eines elektronischen Bauelements, sondern um eine Elektronentransportschicht eines solchen Bauelements handeln. Eine Emission innerhalb der Elektronentransportschicht ist dabei für viele Anwendungen eher nachteilig, da dies die Effizienz des Bauelements meist negativ beeinflusst.

Bevorzugt kann die Gesamtzahl n+m der Liganden am Metallatom M geradzahlig sein, sie kann also bevorzugt 2, 4 oder 6 sein. Besonders bevorzugt ist die Gesamtzahl n+m = 2, da sich derartige Komplexe vergleichsweise leicht mit bekannten Herstellungsverfahren erzeugen lassen.

Die Schichtdicke der elektronenleitenden Schicht kann vorteilhaft zwischen 10 nm und 1000 nm, besonders vorteilhaft zwischen 20 nm und 200 nm liegen. Eine Schichtdicke in einem der genannten Bereiche ist besonders geeignet, um Elektronen zwischen den anderen angrenzenden Schichten eines Schichtstapels in einem organischen elektronischen Bauelement zu transportieren. Bei der Wahl einer noch geringeren Schichtdicke ist die Schicht unter Umständen nicht mehr ausreichend homogen und/oder bildet keine geschlossene Bedeckung der darunterliegenden Schicht. Bei einer wesentlich höheren Schichtdicke ist der Ladungsträgertransport, der beispielsweise durch eine Potentialdifferenz senkrecht zur Schichtebene bewirkt werden kann, gegebenenfalls zu stark eingeschränkt, da bei zu hohen Schichtdicken das lokale elektrische Feld bei gegebener Potentialdifferenz zu gering ist.

Besonders bevorzugt lieg die Zahl m der an das Metallatom M gebundenen Carben-, Vinyliden und/oder Allenylidenliganden zwischen 1 und 2. Auch für derartige Komplexe ist eine relativ einfache Herstellbarkeit der neutralen Komplexformen mit prinzipiell bekannten Herstellungsverfahren gegeben.

Bevorzugt kann die elektronenleitende Schicht zusätzlich zu dem genannten n-Dotierstoff ein weiteres Elektronentransportmaterial aufweisen. Es kann sich also insbesondere um eine Elektronentransportschicht handeln, in die der n-Dotierstoff nur als einer von mehreren Bestandteilen eindotiert und/oder eingemischt ist. Eine solche Einmischung und/oder Eindotierung kann vorteilhaft die Leitfähigkeit des Elektronenmaterials erhöhen.

Bei dem weiteren Elektronentransportmaterial kann es sich beispielsweise um eine oder mehrere der folgenden Verbindungen handeln:
2,2',2"-(1,3,5-Benzinetriyl)-tris(1-phenyl-1-H-benzimidazole); 2-(4-Biphenylyl)-5-(4-tert-butylphenyl)-1,3,4-oxadiazole; 2,9-Dimethyl-4,7-diphenyl-1,10-phenanthroline (BCP); 8-Hydroxyquinolinolato-lithium; 4-(Naphthalen-1-yl)-3,5-diphenyl-4H-1,2,4-triazole; 1,3-Bis[2-(2,2'-bipyridine-6-yl)-1,3,4-oxadiazo-5-yl]benzene; 4,7-Diphenyl-1,10-phenanthroline (BPhen); 3-(4-Biphenylyl)-4-phenyl-5-tert-butylphenyl-1,2,4-triazole; Bis(2-methyl-8-quinolinolate)-4-(phenylphenolato)aluminium; 6,6'-Bis[5-(biphenyl-4-yl)-1,3,4-oxadiazo-2-yl]-2,2'-bipyridyl; 2-phenyl-9,10-di(naphthalen-2-yl)-anthracene; 2,7-Bis[2-(2,2'-bipyridine-6-yl)-1,3,4-oxadiazo-5-yl]-9,9-dimethylfluorene; 1,3-Bis[2-(4-tert-butylphenyl)-1,3,4-oxadiazo-5-yl]benzene; 2-(naphthalen-2-yl)-4,7-diphenyl-1,10-phenanthroline; 2,9-Bis(naphthalen-2-yl)-4,7-diphenyl-1,10-phenanthroline; Tris(2,4,6-trimethyl-3-(pyridin-3-yl)phenyl)borane; 1-methyl-2-(4-(naphthalen-2-yl)phenyl)-1H-imidazo[4,5-f][1,10] phenanthroline; Phenyldipyrenylphosphine oxide; Naphtahlintetracarbonsäuredianhydrid bzw. dessen imide; Perylentetracarbonsäuredianhydrid bzw. dessen imide; 2,3,5,6-tetrafluoro-7,7,8,8-tetracyanoquinodimethane; Pyrazino[2,3-f][1,10]phenanthroline-2,3-dicarbonitrile; Dipyrazino[2,3-f:2',3'-h]quinoxaline-2,3,6,7,10,11-hexacarbonitrile. Weitere einsetzbare Elektronentransportmaterialien sind beispielsweise solche basierend auf Silolen mit einer Silacyclopentadieneinheit oder Heterozyklen, wie in der EP 2 092 041 B1 beschrieben.

Alternativ oder zusätzlich kann die Schicht auch ein Elektronenakzeptormaterial umfassen. Ein solches Elektronenakzeptormaterial kann beispielswese eine oder mehrere der folgenden Verbindungen umfassen:
2,3,5,6-tetrafluoro-7,7,8,8-tetracyano-chinodimethan; Pyrazino[2,3-f][1,10]phenanthrolin-2,3-dicarbonitril und/oder Dipyrazino[2,3-f:2',3'-h]chinoxalin-2,3,6,7,10,11-hexacarbonitril.

Vorteilhaft kann das weitere Elektronentransportmaterial und/oder Elektronenakzeptormaterial eine Matrix bilden, in welche der n-Dotierstoff eingemischt ist. Besonders vorteilhaft kann der Volumenanteil und/oder der Massenanteil zwischen 0,01 % und 35 % liegen. Besonders vorteilhaft kann der Volumenanteil und/oder der Massenanteil zwischen 2 % und 20 % liegen. Bei einem Anteil des n-Dotierstoffes in den genannten Wertebereichen kann vorteilhaft eine besonders wirksame Verbesserung der Elektronenleitfähigkeit der Schicht im Vergleich zum reinen Matrixmaterial erreicht werden.

Alternativ zur Dotierung oder Beimischung in einer Matrix kann der n-Dotierstoff aber auch als Hauptbestandteil der Schicht vorliegen. Insbesondere kann der Volumenanteil und/oder der Massenanteil des n-Dotierstoffes zwischen 70% und 100 % liegen. Bei einem derart hohen Anteil wird die Leitfähigkeit der Schicht hauptsächlich durch die elektrischen Eigenschaften des n-Dotierstoffes bestimmt, was ebenfalls zu sehr guter Elektronenleitfähigkeit der Schicht in einem organischen elektronischen Bauelement führen kann. Es kann also sogar eine Schicht vorliegen, die nur aus dem genannten n-Dotierstoff besteht.

Das organische elektronische Bauelement kann insbesondere als organische Leuchtdiode (=OLED für englisch "organic light emitting diode), als organische Solarzelle, als organischer Photodetektor und/oder als organischer Transistor ausgebildet sein. Bei einem organischen Transistor kann es sich insbesondere um einen organischen Feldeffekttransistor oder um einen organischen Bipolartransistor handeln. Bedingt durch die verbesserten Elektronentransporteigenschaften der erfindungsgemäßen Schicht eignet sich eine solche Schicht besonders zum Aufbau oben genannter organischer elektrischer Bauteile. Es lassen sich dabei insbesondere Bauteile erhalten, welche verbesserte elektronische Eigenschaften, insbesondere geringere Verluste und/oder bessere Effizienzen, und auch verbesserte Standzeiten aufweisen.

Bei der Ausführung des organischen elektronischen Bauelements als OLED kann diese zusätzlich zu der elektronenleitenden Schicht eine separate Emitterschicht aufweisen, welche zwischen der elektronenleitenden Schicht und zumindest einer der Elektroden angeordnet ist. Es soll sich also bei der genannten elektronenleitenden Schicht explizit nicht um die hauptsächlich für die Lichtemission wirksame Emitterschicht der OLED handeln, sondern es soll sich bevorzugt um eine zusätzliche Elektronentransportschicht handeln, welche den Transport von Elektronen zwischen einer der Elektroden und der Emitterschicht bewirkt.

Die Schicht in dem organisch elektronischen Bauelement kann in einer bevorzugten Ausführungsform als Teil einer Ladungserzeugungsschicht (CGL für englisch "charge generation layer") ausgebildet sein. Eine solche Ladungserzeugungsschicht kann bevorzugt wenigstens eine n-leitende Schicht und wenigstens eine p-leitende Schicht umfassen. In der n-leitenden Schicht kann vorteilhaft der erwähnte n-Dotierstoff entsprechend seiner erfindungsgemäßen Verwendung zum Einsatz kommen.

Bei dem Verfahren zur Herstellung der erfindungsgemäßen Schicht kann in einer besonderen Ausgestaltung der n-Dotierstoff zusammen mit mindestens einem Elektronentransportmaterial innerhalb der Schicht abgeschieden werden. Es kann sich hierbei beispielsweise um eine gleichzeitige Abscheidung handeln. Alternativ kann aber auch eine Mehrzahl von aufeinanderfolgenden Teilschichten aus den genannten Materialien sequentiell abgeschieden werden, wodurch insgesamt wieder in der übergeordneten Schicht eine Mischung der einzelnen Komponenten erreicht werden kann.

Der von dem Verfahren umfasste Sublimationsprozess kann vorteilhaft bei einer Temperatur zwischen 120°C und 600°C erfolgen. Hierbei kann vorteilhaft der Druck zwischen 1*10⁻⁵ mbar und 1*10⁻⁹ mbar liegen. Das genannte Prozessfenster ist besonders vorteilhaft dazu geeignet, die beschriebenen n-Dotierstoffe in einer gleichmäßigen Schicht kostengünstig aufzubringen, ohne dabei das Material und insbesondere dessen Elektronentransporteigenschaften zu schädigen.

Bei dem beschriebenen Sublimationsprozess können unabhängig von den genauen Prozessbedingungen der n-Dotierstoff und ein zusätzliches Elektronentransportmaterial gleichzeitig als Schicht ko-resublimiert werden.

Alternativ zu dem genannten Sublimationsprozess (bei dem das sublimierte Material allgemein anschließend in der Schicht resublimiert wird), kann der n-Dotierstoff prinzipiell auch aus einer Flüssigkeit abgeschieden werden. Umfasst die Schicht auch ein weiteres Elektronentransportmaterial, so können beispielsweise beide Stoffe gemeinsam aus einer flüssigen Mischung abgeschieden werden.

Unabhängig von der Zusammensetzung der zu prozessierenden Flüssigkeit (mit oder ohne zusätzliches Elektronentransportmaterial), kann diese Flüssigkeit mit allgemein bekannten Verfahren aus der organischen Halbleitertechnologie prozessiert werden, beispielsweise durch Spincoating, Slotcoating, Rakeln oder verschiedene Druckverfahren wie beispielsweise Inkjetdrucken oder Siebdruck.

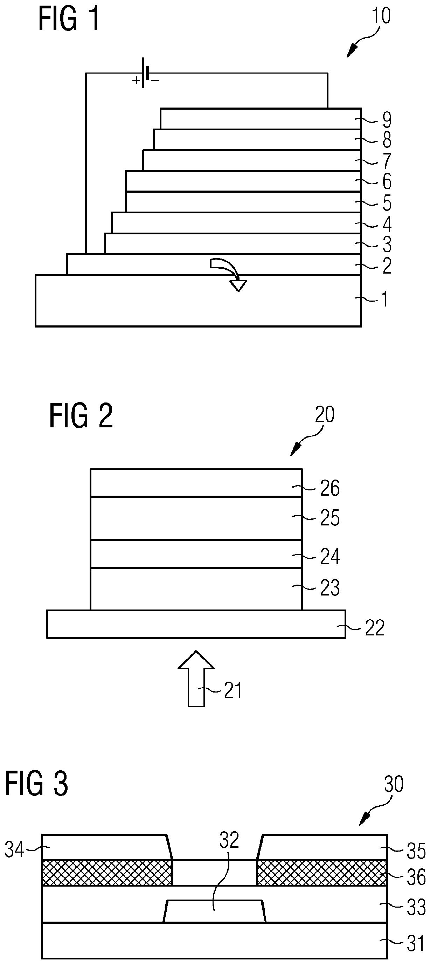

Der Aufbau organisch elektrischer Bauelemente, welche eine erfindungsgemäße Schicht aufweisen können, wird nachfolgend anhand von Figuren näher erläutert. Es zeigen
- Fig. 1: schematisch den Aufbau einer organischen Leuchtdiode (10). Die Leuchtdiode umfasst eine Glas-Schicht (1); Indium-Zinn-Oxid (ITO)-Schicht (2); Loch-Injektor-Schicht (3); Loch-Transportschicht (HTL) (4); Emitter-Schicht (EML) (5); Loch-Blocker-Schicht (HBL) (6); Elektronen-Transportschicht (ETL) (7); Elektronen-Injektorschicht (8)und einer Kathoden-Schicht (9) ;
- Fig. 2: schematisch den Aufbau einer organischen Solarzelle oder eines organischen Photodetektors mit PIN-Struktur (20), welche Licht (21) in elektrischen Strom umwandelt. Das Bauteil umfasst eine Schicht aus Indium-Zinn-Oxid (22); einer p-dotierten Schicht (23); einer Absorptions-Schicht (24); einer n-dotierten Schicht (25) und einer Metall-Schicht (26);
- Fig. 3: schematisch einen möglichen Querschnitt eines organischen Feld-Effekt-Transistors (30). Auf einem Substrat (31) ist eine Gate-Elektrode (32), ein GateDielektrikum (33), ein Source und Drain-Kontakt (34 + 35) und ein organischer Halbleiter (36) aufgebracht. Die schraffierten Stellen zeigen die Stellen, an denen eine Kontaktdotierung hilfreich ist und

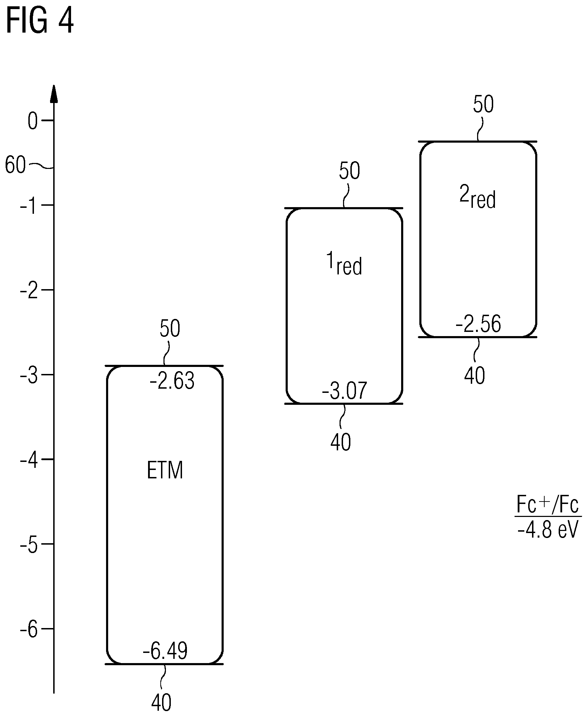

- Fig. 4: schematisch die Lagen der Molekülorbitale für zwei beispielhafte n-Dotierstoffe im Vergleich zu einem beispielhaften Elektronentransportmaterial.

Die Vorteile der vorliegenden Erfindung kommen daher besonders zum Einsatz, wenn beispielsweise die Elektronentransportschicht 7 der organischen Leuchtdiode 10 der Fig. 1 als erfindungsgemäße Schicht ausgestaltet ist. Bei einer derart ausgestalteten organischen Leuchtdiode kann die Lumineszenz (in cd/m2), die Effizienz (in cd/A) und/oder die Lebensdauer (in h) im Vergleich zu herkömmlichen OLEDs erhöht werden, da diese Kenngrößen von der Exzitonendichte in der lichtemittierenden Schicht 5 und/oder der Qualität der Ladungsträgerinjektion in diese Schicht abhängen. Beide Eigenschaften können durch die Erhöhung der Elektronenleitfähigkeit in der Elektronentransportschicht 7 verbessert werden.

Die Vorteile kommen auch zum Tragen, wenn beispielsweise die n-dotierte Schicht 25 der organischen Solarzelle 20 gemäß Fig. 2 als erfindungsgemäße Schicht ausgestaltet ist. Alternativ kann ein organisches Bauelement mit einem Schichtaufbau gemäß Fig. 2 auch als organischer Photodetektor zum Einsatz kommen. Die Effizienz einer solchen Solarzelle und/oder eines solchen Photodetektors ist besonders hoch, wenn möglichst wenig Spannung über eine solche n-dotierte Elektronentransportschicht 25 abfällt.

Die Vorteile kommen auch zum Tragen, wenn beispielsweise die schraffierten Bereiche der Halbleiterschicht 36 als erfindungsgemäße Schicht ausgestaltet sind. Durch die erfindungsgemäße Ausgestaltung dieser Teile der Schicht 36 können die Kontaktwiederstände dort besonders klein gehalten werden, was insgesamt zu einer hohen effektiven Mobilität der Ladungsträger im Bauelement führt. In Schaltkreisen mit solchen Transistoren können so besonders hohe Schaltfrequenzen erreicht werden.

### Beispiel 1

Eine Schicht nach einem ersten Ausführungsbeispiel der Erfindung umfasst einen n-Dotierstoff, wie er sich durch die untenstehende Formel (5) ergibt:

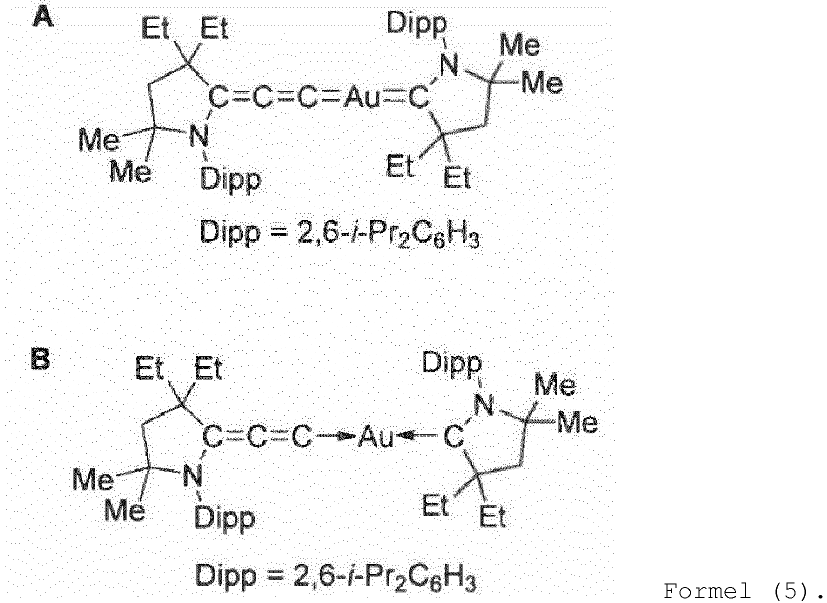

Gezeigt sind zwei alternative Strukturformeln A und B desselben Komplexes, bei dem es sich insgesamt um eine formal neutrale Verbindung handelt. Das Metallatom ist hier Gold. Man kann dabei dem Goldatom formal die Oxidationsstufe Null zuordnen und rechts dargestellten Carben-Liganden und den links dargestellten Allenyliden-Liganden als neutral betrachten. Aus Berechnungen ergibt sich jedoch, dass die Elektronendichte am Goldatom eher gering ist und man diese Komplexe deshalb auch als Au(I)-Komplexe mit einem anionischen paramagnetischen Allenyliden-Liganden betrachten kann. Man kann eine solche Verbindung schematisch sowohl als Struktur A mit Doppelbindungen, als auch als Struktur B mit einem Koordinationspfeil darstellen. Beide Schreibweisen sind hier mit eingeschlossen. Auch bei den allgemeinen Komplexen des Typs nach Formel (1) sollen insgesamt alle solchen Komplexstrukturen als erfindungsgemäß gelten, die sich schematisch durch eine dieser entsprechenden Formeln wiedergeben lassen. Strukturen, die sich gemäß ihrer Elektronendichte alternativ oder möglicherweise auch besser durch eine andere schematische Schreibweise darstellen lassen, sollen dabei erfindungsgemäß mit eingeschlossen sein.

Die Herstellung der erfindungsgemäßen Komplexe kann allgemein, beispielsweise in ihrem letzten Schritt, eine Reduktion eines kationischen Vorgängers umfassen. In umgekehrter Weise kann in der erfindungsgemäßen Schicht, beispielsweise wenn diese ein weiteres Material enthält, wieder ein Elektron auf dieses Material übertragen werden. Insbesondere kann die Schicht ein Elektronentransportmaterial, beispielsweise aus der vorab genannten Liste, enthalten. Dann kann ein Elektron auf das Elektronentransportmaterial (ETM) übertragen werden, wie aus dem untenstehenden Reaktionsschema ersichtlich ist: 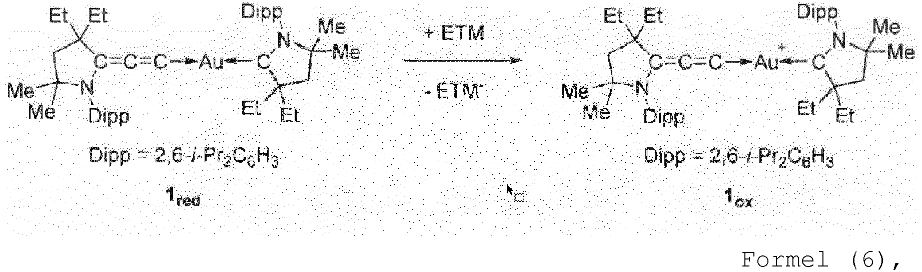 wobei i-Pr = iso-Propyl (-CH(CH3)2) ist.

Gemäß diesem Schema wird der linksstehend gezeigte Komplex nach dem ersten Ausführungsbeispiel, der in seiner reduzierten Form 1_{red} vorliegt, durch Elektronenübertragung an das Elektronentransportmaterial ETM, welches ebenfalls innerhalb derselben Schicht vorliegen kann, in seine oxidierte Form 1ₒₓ überführt. Durch die Übertragung des Elektrons wird dagegen im Elektronentransportmaterial die reduzierte Form ETM⁻ gebildet, wodurch der Elektronentransport durch eine erhöhte Anzahlt freier Ladungsträger (Elektronen) in diesem Material entscheidend verbessert wird.

Allgemein sollen bei den erfindungsgemäßen Komplexen die den Strukturen der Formel (1) entsprechenden oxidierten Formen analog zu 1ₒₓ mit eingeschlossen sein. Insbesondere bei den genannten Anteilen dieses Komplexes in derartigen Schichten, in denen auch noch ein weiteres Material vorliegt, sollen auch diese oxidierten Formen als Teil dieses Anteils verstanden werden.

Alternativ oder zusätzlich zu der gezeigten Oxidation des Komplexes kann auch ein Charge-Transfer-Komplex mit dem Komplex gemäß allgemeiner Formel (1) als Donor und dem Elektronentransportmaterial als Akzeptor gebildet werden. Mit anderen Worten ist es nicht zwingend notwendig, dass ein ganzes Elektron im Sinne einer chemischen Oxidation übertragen wird. Es kann auch eine teilweise Übertragung im Sinne einer zusätzlichen Komplexbildung in Form eines Charge-Transfer-Komplexes vorliegen. Auch in diesem Fall wird der Vorteil erreicht, dass durch die teilweise Übertragung eines Elektrons auf das Elektronentransportmaterial dessen Leitfähigkeit erhöht wird.

Der beschriebene (vollständige oder anteilige) Transfer eines Elektrons von dem Komplex auf das Elektronentransportmaterial ist für die erfindungsgemäßen Komplexe der Struktur nach Formel (1) besonders begünstigt, da diese Komplexe äußerst elektronenreich sind. So weist der Komplex 1ₒₓ nach dem ersten Ausführungsbeispiel ein Reduktionspotential von -1,73 V versus Fc⁺/Fc auf. Fc⁺ entspricht dabei dem Ferrocenium-Kation und Fc entspricht Ferrocen. Die reversible Oxidation von Fc zu Fc⁺ wird dabei als interne Referenz (analog einer Referenzelektrode) in der elektrochemischen Bestimmung von Oxidations- und Reduktionspotentialen mittels Cyclovoltammetrie verwendet. Dieses Reduktionspotential entspricht einer Lage des HOMO von -3.07 eV gegenüber dem Vakuumniveau für den n-Dotierstoff 1_{red}.

### Beispiel 2

Eine Schicht nach einem zweiten Ausführungsbeispiel der Erfindung umfasst einen alternativen zweiten n-Dotierstoff, wie er sich durch die untenstehende Formel (7) ergibt:

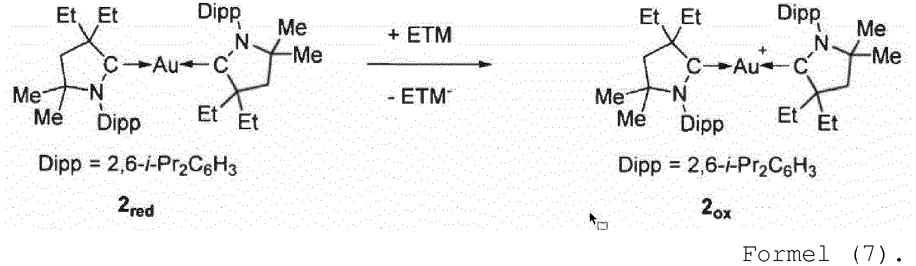

Auch hier ist die reduzierte Form des zweiten n-Dotierstoffs 2_{red} links als in der Schicht vorliegender Ausgangsstoff gezeigt, während im rechten Teil des Schemas der Formel (7) die oxidierte Form 2ₒₓ gezeigt ist, die beispielsweise durch Übertragung eines Elektrons an ein ebenfalls in der Schicht vorliegendes Elektronentransportmaterial (ETM) erhältlich ist. Für diesen zweiten n-Dotierstoff ist der reduzierte Komplex 2_{red} sogar ein noch stärkerer Elektronendonor als der entsprechende reduzierte Komplex 1_{red}. So weist 2_{red} ein Oxidationspotential von -2,24 V versus Fc⁺/Fc auf, was einer Lage des HOMOs von -2,56 eV gegenüber dem Vakuumniveau entspricht. Ein derart hoch liegendes HOMO ist sogar noch günstiger für die Förderung der Elektronenleitfähigkeit in der Schicht als bei dem ersten beschriebenen n-Dotierstoff.

Fig. 4 illustriert die Lagen der HOMOs und der LUMOs (LUMO = niedriges unbesetztes Molekülorbital, für englisch "lowest unoccupied molecular orbital") für die beiden beschriebenen n-Dotierstoffe 1_{red} und 2_{red} im Vergleich mit einem beispielhaften Elektronentransportmaterial ETM mit typischen Lagen der Molekülorbitale. Die vertikalen Höhen der gezeigten Kästchen symbolisieren dabei jeweils die Bandlücke der Materialien, wobei das jeweilige HOMO durch das Bezugszeichen 40 und das jeweilige LUMO durch das Bezugszeichen 50 gekennzeichnet ist. Dabei ist die Lage des LUMO ein näherungsweiser Wert. Die Werte auf der Achse 60 geben dabei das Niveau dieser Molekülorbitale in Elektronenvolt (eV) gegenüber Vakuum an. Zum Vergleich ist noch die Lage des Fc⁺/Fc-Niveaus gezeigt, aus welchem sich die HOMO Lagen anhand der Oxidationspotentiale berechnen lassen. Eine Elektronenübertragung vom HOMO des Komplexes 1_{red} auf das LUMO des Elektronentransportmaterials ist leicht möglich, da dieses LUMO zwar höher, aber energetisch sehr nah an dem HOMO von 1_{red} liegt. Durch ein besetztes LUMO im Elektronentransportmaterial wird aber gerade ein effizienter Elektronentransport in diesem Material ermöglicht. Noch günstiger ist die Situation für den Komplex 2_{red}, da hier das HOMO mit -2,56 eV sogar noch höher liegt. Dies ist ein außergewöhnliches Beispiel, bei dem das LUMO des Elektronentransportmaterials liefer liegt als das HOMO eines hierin eingemischten n-Dotierstoffes.

### Beispiel 3

Eine Schicht nach einem dritten Ausführungsbeispiel der Erfindung umfasst einen alternativen dritten n-Dotierstoff, wie er sich durch die untenstehende allgemeine Formel (8) ergibt:

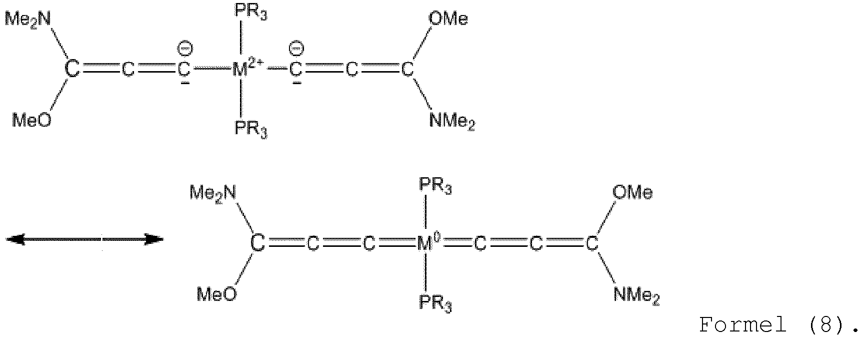

Hierin ist das Metallatom M ausgewählt aus der Gruppe umfassend Palladium oder Platin, und die Reste R der beiden Phosphoratome sind unabhängig voneinander ausgewählt aus der Gruppe der Alkyl- und/oder Arylreste. Es handelt sich um einen Bis(allenyliden)-Komplex, der sich beispielsweise aus einem entsprechenden zweifach geladenen Komplex-Kation durch Reduktion mit einem starken Reduktionsmittel wie C₈K erhalten lässt. Auch hier lässt sich ein solches Kation wieder erzeugen, indem Elektronen an ein ebenfalls innerhalb der erfindungsgemäßen Schicht vorliegendes Elektronentransportmaterial übertragen werden. Bei diesem dritten Beispiel können also sogar zwei Elektronen pro Komplexmolekül zu dem Elektronentransportmaterial transferiert werden, was für die Erhöhung der Elektronenleitfähigkeit in diesem Material ganz besonders günstig ist.

Die Schichten gemäß den drei beschriebenen Ausführungsbeispielen können beispielsweise als Elektronentransportschichten in den verschiedenen vorab beschriebenen Bauteiltypen verwendet werden. So lassen sich die unterschiedlichen erfindungsgemäßen Schichten vorteilhaft beispielsweise als Schicht 7 der in Fig. 1 gezeigten OLED 10, als Schicht 25 der in Fig. 2 gezeigten Solarzelle oder als schraffierter Teilbereich der Schicht 36 in dem in Fig. 3 gezeigten Transistor einsetzen.

## Patentansprüche

1. Organische elektronenleitende Schicht (7, 25, 36), umfassend einen n-Dotierstoff mit der Struktur 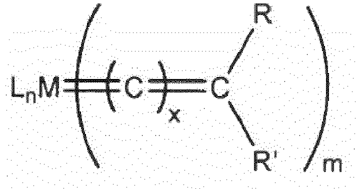
- wobei Lₙ eine Anzahl n von Liganden L bezeichnet, die unabhängig voneinander aus der Gruppe der Alkyle, Aryle, Alkylaryle, Heteroalkyle, Heteroaryle, der mit funktionellen Gruppen substituierten Alkyle, Aryle, Alkylaryle, Heteroalkyle, Heteroaryle und der substituierten Heteroatome ausgewählt sind,
- wobei M ein Metall ist, ausgewählt aus der Gruppe enthaltend Eisen, Ruthenium, Osmium, Kobalt, Rhodium, Iridium, Nickel, Palladium, Platin, Kupfer, Silber und Gold,
- wobei R und R' unabhängig voneinander aus der Gruppe der Alkyle, Aryle, Alkylaryle, Heteroalkyle, Heteroaryle, der mit funktionellen Gruppen substituierten Alkyle, Aryle, Alkylaryle, Heteroalkyle, Heteroaryle und der substituierten Heteroatome ausgewählt sind,
- wobei n zwischen 0 und 5 liegt,
- wobei m zwischen 1 und 6 liegt,
- wobei n+m zwischen 2 und 6 liegt
- und wobei x einen Wert von 0, 1 oder 2 hat.

2. Schicht (7, 25, 36) nach Anspruch 1, wobei R und/oder R' ein substituiertes Heteroatom, insbesondere ein substituiertes Stickstoffatom, ist.

3. Schicht (7, 25, 36) nach einem der Ansprüche 1 oder 2,
- wobei M ausgewählt ist aus der Gruppe enthaltend Palladium, Platin, Silber und Gold.

4. Schicht (7, 25, 36) nach einem der vorhergehenden Ansprüche,
welche als Teil einer Ladungserzeugungsschicht ausgebildet ist.

5. Schicht (7, 25, 36) nach einem der vorhergehenden Ansprüche,
deren Schichtdicke zwischen 10 Nanometer und 1000 Nanometer, insbesondere zwischen 20 Nanometer und 200 Nanometer liegt.

6. Schicht (7, 25, 36) nach einem der vorhergehenden Ansprüche, bei der n wenigstens zwei ist und die wenigstens zwei Liganden L als übergeordnete Ringstruktur miteinander verbrückt sind.

7. Schicht (7, 25, 36) nach einem der vorhergehenden Ansprüche, welche zusätzlich zu dem n-Dotierstoff ein weiteres Elektronentransportmaterial (ETM) und/oder Elektronenakzeptormaterial aufweist.

8. Schicht (7, 25, 36) nach Anspruch 7, bei welchem das weitere Elektronentransportmaterial (ETM) und/oder Elektronenakzeptormaterial eine Matrix bildet, in welche der n-Dotierstoff eingemischt ist, insbesondere mit einem Volumenanteil zwischen 0,01 % und 35 %-vol.

9. Schicht (7,25,36) nach einem der Ansprüche 1 bis 7, bei welchem der Volumenanteil des n-Dotierstoffes zwischen 70 % und 100 % liegt.

10. Organisches elektronisches Bauelement (10, 20, 30) mit wenigstens zwei Elektroden (2,9; 23,36; 32,34,35) und einer Schicht (7,25,36) nach einem der vorhergehenden Ansprüche.

11. Organisches elektronisches Bauelement nach Anspruch 10, welches als organische Leuchtdiode (10), als organische Solarzelle (20), als organischer Photodetektor (20) und/oder als organischer Transistor (30) ausgestaltet ist.

12. Organisches elektronisches Bauelement (10) nach Anspruch 11, welches als organische Leuchtdiode ausgestaltet ist, welche zusätzlich zu der elektronenleitenden Schicht eine separate Emitterschicht (5) aufweist, welche zwischen der elektronenleitenden Schicht (7) und zumindest einer der Elektroden (2) angeordnet ist.

13. Verfahren zur Herstellung einer organischen elektronenleitenden Schicht (7, 25, 36) nach einem der Ansprüche 1 bis 9, wobei der n-Dotierstoff mittels eines Sublimationsprozesses abgeschieden wird.

14. Verfahren nach Anspruch 13, wobei der n-Dotierstoff zusammen mit mindestens einem Elektronentransportmaterial (ETM) innerhalb der Schicht abgeschieden wird.

15. Verwendung eines n-Dotierstoffes mit der Struktur 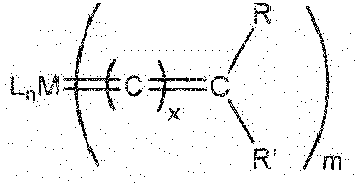
- wobei Lₙ eine Anzahl n von Liganden L bezeichnet, die unabhängig voneinander aus der Gruppe der Alkyle, Aryle, Alkylaryle, Heteroalkyle, Heteroaryle, der mit funktionellen Gruppen substituierten Alkyle, Aryle, Alkylaryle, Heteroalkyle, Heteroaryle und der substituierten Heteroatome ausgewählt sind,
- wobei M ein Metall ist, ausgewählt aus der Gruppe enthaltend Eisen, Ruthenium, Osmium, Kobalt, Rhodium, Iridium, Nickel, Palladium, Platin, Kupfer, Silber und Gold,
- wobei R und R' unabhängig voneinander aus der Gruppe der Alkyle, Aryle, Alkylaryle, Heteroalkyle, Heteroaryle, der mit funktionellen Gruppen substituierten Alkyle, Aryle, Alkylaryle, Heteroalkyle, Heteroaryle und der substituierten Heteroatome ausgewählt sind,
- wobei n zwischen 0 und 5 liegt,
- wobei m zwischen 1 und 6 liegt,
- wobei n+m zwischen 2 und 6 liegt
- und wobei x einen Wert von 0, 1 oder 2 hat,
zur Erhöhung der Elektronenleitfähigkeit einer organischen Schicht (7,25,36).

## Claims

1. Organic electron-conducting layer (7, 25, 36), comprising an n-dopant having the structure 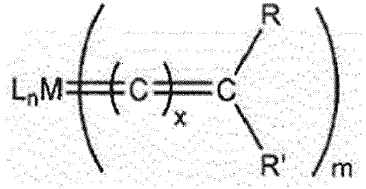
- where Lₙ denotes a number n of ligands L that are independently selected from the group of the alkyls, aryls, alkylaryls, heteroalkyls, heteroaryls, the alkyls, aryls, alkylaryls, heteroalkyls, heteroaryls substituted by functional groups, and the substituted heteroatoms,
- where M is a metal selected from the group comprising iron, ruthenium, osmium, cobalt, rhodium, iridium, nickel, palladium, platinum, copper, silver and gold,
- where R and R' are independently selected from the group of the alkyls, aryls, alkylaryls, heteroalkyls, heteroaryls, the alkyls, aryls, alkylaryls, heteroalkyls, heteroaryls substituted by functional groups, and the substituted heteroatoms,
- where n is from 0 to 5,
- where m is from 1 to 6,
- where n + m is from 2 to 6
- and where x has a value of 0, 1 or 2.

2. Layer (7, 25, 36) according to Claim 1, wherein R and/or R' is a substituted heteroatom, especially a substituted nitrogen atom.

3. Layer (7, 25, 36) according to either of Claims 1 or 2,
- where M is selected from the group comprising palladium, platinum, silver and gold.

4. Layer (7, 25, 36) according to any of the preceding claims, which forms part of a charge generation layer.

5. Layer (7, 25, 36) according to any of the preceding claims, having a layer thickness between 10 nanometers and 1000 nanometers, especially between 20 nanometers and 200 nanometers.

6. Layer (7, 25, 36) according to any of the preceding claims, in which n is at least two and the at least two ligands L are bridged to one another in the form of a higher ring structure.

7. Layer (7, 25, 36) according to any of the preceding claims, having, in addition to the n-dopant, a further electron transport material (ETM) and/or electron acceptor material.

8. Layer (7, 25, 36) according to Claim 7, in which the further electron transport material (ETM) and/or electron acceptor material forms a matrix into which the n-dopant has been mixed, especially with a proportion by volume between 0.01% and 35% by volume.

9. Layer (7, 25, 36) according to any of Claims 1 to 7, in which the proportion by volume of the n-dopant is between 70% and 100%.

10. Organic electronic component (10, 20, 30) having at least two electrodes (2, 9; 23, 36; 32, 34, 35) and a layer (7, 25, 36) according to any of the preceding claims.

11. Organic electronic component according to Claim 10, configured as an organic light-emitting diode (10), as an organic solar cell (20), as an organic photodetector (20) and/or as an organic transistor (30).

12. Organic electronic component (10) according to Claim 11, configured as an organic light-emitting diode which, in addition to the electron-conducting layer, has a separate emitter layer (5) disposed between the electron-conducting layer (7) and at least one of the electrodes (2).

13. Process for producing an organic electron-conducting layer (7, 25, 36) according to any of Claims 1 to 9, wherein the n-dopant is deposited by means of a sublimation process.

14. Process according to Claim 13, wherein the n-dopant is deposited within the layer together with at least one electron transport material (ETM).

15. Use of an n-dopant having the structure 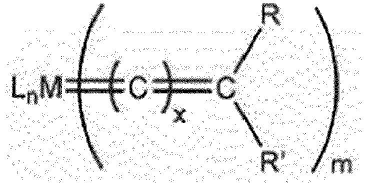
- where Lₙ denotes a number n of ligands L that are independently selected from the group of the alkyls, aryls, alkylaryls, heteroalkyls, heteroaryls, the alkyls, aryls, alkylaryls, heteroalkyls, heteroaryls substituted by functional groups, and the substituted heteroatoms,
- where M is a metal selected from the group comprising iron, ruthenium, osmium, cobalt, rhodium, iridium, nickel, palladium, platinum, copper, silver and gold,
- where R and R' are independently selected from the group of the alkyls, aryls, alkylaryls, heteroalkyls, heteroaryls, the alkyls, aryls, alkylaryls, heteroalkyls, heteroaryls substituted by functional groups, and the substituted heteroatoms,
- where n is from 0 to 5,
- where m is from 1 to 6,
- where n + m is from 2 to 6
- and where x has a value of 0, 1 or 2,
for increasing the electron conductivity of an organic layer (7, 25, 36).

## Revendications

1. Couche (7, 25, 36) organique conduisant les électrons, comprenant une substance de dopage n de structure 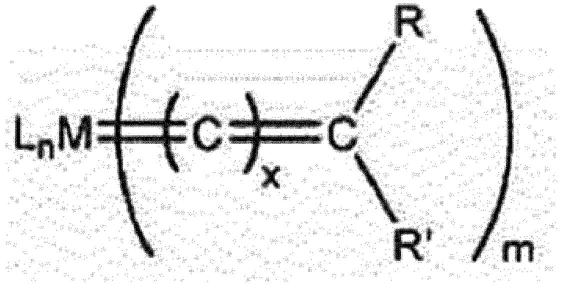
- dans laquelle Ln désigne un nombre n de ligands L, qui sont choisis indépendamment les uns des autres dans le groupe des alcoyle, aryle, alcoylaryle, hétéroalcoyle, hétéroaryle, des alcoyle, aryle, alcoylaryle, hétéroalcoyle, hétéroaryle substitués par des groupes fonctionnels et des hétéroatomes substitués,
- dans laquelle M est un métal choisi dans le groupe contenant le fer, le ruthénium, l'osmium, le cobalt, le rhodium, l'iridium, le nickel, le palladium, le platine, le cuivre, l'argent et l'or,
- dans laquelle R et R' sont choisis indépendamment l'un de l'autre dans le groupe des alcoyle, aryle, alcoylaryle, hétéroalcoyle, hétéroaryle, des alcoyle, aryle, alcoylaryle, hétéroalcoyle, hétéroaryle substitués par des groupes fonctionnels et des hétéroatomes substitués,
- dans laquelle n est compris entre 0 et 5,
- dans laquelle m est compris entre 1 et 6,
- dans laquelle n+m est compris entre 2 et 6,
- et dans laquelle x a une valeur de 0, 1 ou 2.

2. Couche (7, 25, 36) suivant la revendication 1, dans laquelle R et/ou R' est un hétéroatome substitué, notamment un atome d'azote substitué.

3. Couche (7, 25, 36) suivant l'une des revendications 1 ou 2,
- dans laquelle M est choisi dans le groupe contenant le palladium, le platine, l'argent et l'or.

4. Couche (7, 25, 36) suivant l'une des revendications précédentes,
qui est constituée comme partie d'une couche de production de charge.

5. Couche (7, 25, 36) suivant l'une des revendications précédentes,
dont l'épaisseur de couche est comprise entre 10 nanomètres et 100 nanomètres, notamment entre 20 nanomètres et 200 nanomètres.

6. Couche (7, 25, 36) suivant l'une des revendications précédentes, dans laquelle n est au moins égal à 2 et les au moins deux ligans sont pontés l'un à l'autre en une structure cyclique surajoutée.

7. Couche (7, 25, 36) suivant l'une des revendications précédentes, qui a, en plus de la substance de dopage n, une autre matière (ETM) de transport d'électrons et/ou matière d'accepteur d'électrons.

8. Couche (7, 25, 36) suivant la revendication 7, dans laquelle l'autre matière (ETM) de transport d'électrons et/ou l'autre matière d'accepteur d'électrons forme une matrice, dans laquelle est mélangée la substance de dopage n, notamment en une proportion en volume comprise entre 0,01 % et 35 % en volume.

9. Couche (7, 25, 36) suivant l'une des revendications 1 à 7, dans laquelle la proportion en volume de la substance de dopage n est comprise entre 70 % et 100 %.

10. Composant (10, 20, 30) organique électronique comprenant au moins deux électrodes (2, 9 ; 23, 36 ; 32, 34, 35) et, une couche (7, 25, 36) suivant l'une des revendications précédentes.

11. Composant électronique organique suivant la revendication 10, qui est conformé en diode (10) électroluminescente organique, en cellule (20) solaire organique, en photodétecteur (20) organique et/ou en transistor (30) organique.

12. Composant électronique organique suivant la revendication 11, qui est conformé en diode (10) électroluminescente organique, qui a, en plus de la couche conduisant les électrons, une couche (5) distincte formant émetteur, qui est disposée entre la couche (7) conduisant les électrons et au moins l'une des électrodes (2).

13. Procédé de production d'une couche (7, 25, 36) organique conduisant les électrons suivant l'une des revendications 1 à 9, dans lequel on dépose la substance de dopage n au moyen d'un processus de sublimation.

14. Procédé suivant la revendication 13, dans lequel on dépose au sein de la couche la substance de dopage n ensemble avec au moins une matière (ETM) de transport d'électrons.

15. Utilisation d'une substance de dopage n ayant la structure 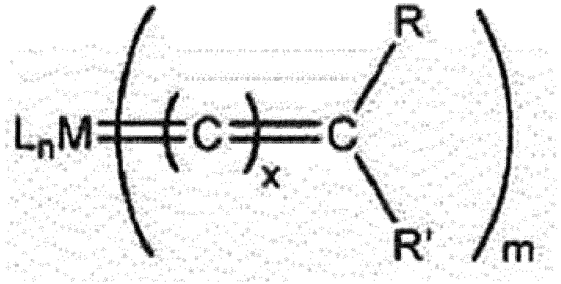
- dans laquelle Lₙ désigne un nombre n de ligands L ,qui sont choisis indépendamment les uns des autres dans le groupe des alcoyle, aryle, alcoylaryle, hétéroalcoyle, hétéroaryle, des alcoyle, aryle, alcoylaryle, hétéroalcoyle, hétéroaryle substitués par des groupes fonctionnels et des hétéroatomes substitués,
- dans laquelle M est un métal choisi dans le groupe contenant le fer, le ruthénium, l'osmium, le cobalt, le rhodium, l'iridium, le nickel, le palladium, le platine, le cuivre, l'argent et l'or,
- dans laquelle R et R' sont choisis indépendamment l'un de l'autre dans le groupe des alcoyle, aryle, alcoylaryle, hétéroalcoyle, hétéroaryle, des alcoyle, aryle, alcoylaryle, hétéroalcoyle, hétéroaryle substitués par des groupes fonctionnels et des hétéroatomes substitués,
- dans laquelle n est compris entre 0 et 5,
- dans laquelle m est compris entre 1 et 6,
- dans laquelle n+m est compris entre 2 et 6,
- et dans laquelle x a une valeur de 0, 1 ou 2.
pour augmenter la conductivité des électrons d'une couche (7, 25, 36) organique.
